# EUROPÄISCHE PATENTSCHRIFT

(11) **EP 1 774 599 B1**
(45) Veröffentlichungstag und Bekanntmachung des Hinweises auf die Patenterteilung: **04.11.2015**
(21) Anmeldenummer: 05770659.0
(22) Anmeldetag: 20.07.2005
(51) Int. Cl.: H01L 21/78, H01L 23/00, H01L 23/31, H01L 21/683, H01L 33/00, H01L 33/40, H01L 33/62

(54) **VERFAHREN ZUR HERSTELLUNG VON HALBLEITERCHIPS IN DÜNNFILMTECHNIK UND HALBLEITERCHIP IN DÜNNFILMTECHNIK**
METHOD FOR PRODUCING SEMICONDUCTOR CHIPS USING THIN-FILM TECHNOLOGY AND A SEMICONDUCTOR CHIP PRODUCED USING THIN-FILM TECHNOLOGY
PROCEDE POUR FABRIQUER DES PUCES SEMI-CONDUCTRICES SELON LA TECHNIQUE DES COUCHES MINCES ET PUCE SEMI-CONDUCTRICE FABRIQUEE SELON LA TECHNIQUE DES COUCHES MINCES

(30) Priorität: 30.07.2004 DE 102004036962; 30.07.2004 US 592969 P
(43) Veröffentlichungstag der Anmeldung: 18.04.2007
(73) Patentinhaber: OSRAM Opto Semiconductors GmbH, 93055 Regensburg (DE)
(72) Erfinder: HAHN, Berthold, 93155 Hemau (DE); HÄRLE, Volker, 93164 Laaber (DE); KAISER, Stephan, 93047 Regensburg (DE); PLÖSSL, Andreas, 93051 Regensburg (DE)
(74) Vertreter: Epping - Hermann - Fischer
(86) Internationale Anmeldenummer: PCT/DE2005/001276
(87) Internationale Veröffentlichungsnummer: WO 2006/012838

(56) Entgegenhaltungen:
- US-A- 5 724 376
- US-A1- 2004 026 709
- US-A1- 2004 077 114

## Beschreibung

Die Erfindung betrifft ein Verfahren nach Anspruch 1 zur Herstellung von Halbleiterchips in Dünnfilmtechnik und einen Halbleiterchip nach Anspruch 15 in Dünnfilmtechnik (Dünnfilm-Halbleiterchip).

Dünnfilm-Halbleiterchips sind beispielsweise aus der Druckschrift EP 0 905 797 A2 bekannt. Zur Herstellung derartiger Dünnfilm-Halbleiterchips wird eine aktive Schichtenfolge, die geeignet ist, Photonen zu emittieren, auf einem Wachstumssubstrat aufgewachsen. Da das Wachstumssubstrat meist einen Teil der von der aktiven Schichtenfolge erzeugten Photonen absorbiert, wird zur Erhöhung der Lichtausbeute die aktive Schichtenfolge vom Wachstumssubstrat getrennt und auf einen anderen Träger aufgebracht. Zwischen dem Träger und der aktiven Schichtenfolge befindet sich eine reflektierende Schicht. Die Verbindung zwischen aktiver Schichtenfolge und Träger wird durch Kleben oder Löten hergestellt. Üblicherweise werden starre Träger, wie Galliumarsenid- oder Germanium-Wafer verwendet. Diese haben jedoch den Nachteil, dass die Trägerdicke aufgrund des Bruchrisikos nicht beliebig reduziert werden kann. Insbesondere ist es schwierig mit herkömmlichen Verfahren Trägerdicken unter 100 µm zu realisieren. Dies stellt eine Hürde zur Limitierung der Bauhöhe von Dünnfilm-Halbleiterchips dar.

In der Druckschrift US 2004/0077114 ist ein Herstellungsverfahren für Licht emittierende Bauelemente beschrieben, bei dem auf einem Wachstumssubstrat aufgewachsene InAlGaN-Schichten mittels Bonding-Schichten mit einem Silizium-Träger verbunden werden.

In der Druckschrift US 5,725,376 ist ein Verfahren zur Herstellung von oberflächenemittierenden Lasern (vertical cavity surface emitting lasers, VCSELs) mittels Wafer-Bondens dargestellt, mit dem die aktiven Schichten der VCSELs näher an einer Wärmesenke platziert werden sollen.

Ein weiterer Nachteil der bekannten Dünnfilm-Halbleiterchips ist, dass die Übertragung der aktiven Schichtenfolge vom Substrat auf den Trägerkörper schwierig zu handhaben ist.

Zur Verminderung dieses Problems ist in der DE 100 40 448 A1 vorgeschlagen, rückseitig auf die Kontaktmaterialschichten eine Verstärkungsschicht und eine Hilfsträgerschicht aufzubringen. Diese ersetzen den in herkömmlichen Verfahren verwendeten mechanischen Träger und ermöglichen die vereinfachte Handhabung der aktiven Schichtenfolge.

Allerdings ist es bei diesem Verfahren nicht oder nur sehr aufwändig möglich, die Funktion aller späteren Dünnfilm-Halbleiterchips nach dem Übertragen der aktiven Schichtenfolge auf den Hilfsträger auf Wafer-Level zu testen.

Eine Aufgabe der vorliegenden Erfindung ist es, ein vereinfachtes Verfahren zur Herstellung von Halbleiterchips mit geringer Höhe in Dünnfilmtechnik anzugeben, wobei es möglich sein soll, die späteren Dünnfilm-Halbleiterchips auf Wafer-Level einfach zu testen. Weiterhin ist es Aufgabe der vorliegenden Erfindung, einen Dünnfilm-Halbleiterchip mit geringer Bauhöhe bei gleichzeitig guter mechanischer Stabilität anzugeben.

Diese Aufgaben werden durch ein Verfahren nach Patentanspruch 1 und einen Halbleiterchip nach Patentanspruch 15 gelöst. Vorteilhafte Weiterbildungen des Verfahrens und des Halbleiterchips sind in den Unteransprüchen 2 bis 14 bzw. 16 bis 21 zu finden.

Ein Verfahren zur Herstellung von Dünnfilm-Halbleiterchips beinhaltet die Schritte:
- Aufbringen einer aktiven Epitaxie-Schichtenfolge auf ein Wachstumssubstrat, die geeignet ist, elektromagnetische Strahlung zu erzeugen,
- Ausbilden einer reflektierenden elektrisch leitfähigen Kontaktmaterialschicht auf der aktiven Schichtenfolge,
- Strukturieren der aktiven Schichtenfolge einschließlich Kontaktmaterialschicht zu voneinander getrennten aktiven Schichtenstapeln auf dem Wachstumssubstrat,
- Aufbringen einer flexiblen, elektrisch leitfähigen Folie auf der elektrisch leitfähige, reflektierende Kontaktmaterialschicht, und
- zumindest teilweises Entfernen des Wachstumssubstrat.

Alternativ kann die Kontaktmaterialschicht, beispielsweise mittels Maskentechnologie, auch lateral strukturiert aufgebracht werden und anschließend nur die darunter liegende aktive Schichtenfolge so strukturiert werden, dass sich je eine Kontaktmaterialschicht auf einem aktiven Schichtstapel befindet. Die Kontaktmaterialschicht enthält bevorzugt ein Metall.

Dieses Verfahren bietet den Vorteil, dass die mit der Kontaktmaterialschicht versehenen Rückseiten der Dünnfilm-Halbleiterchips über die flexible Folie untereinander elektrisch leitend verbunden sind und folglich jeder Dünnfilm-Halbleiterchip mit Hilfe von jeweils einer weiteren Kontaktierung auf seiner der Kontaktmaterialschicht gegenüberliegenden Vorderseite einfach auf Wafer-Level getestet werden können.

Die Verwendung der elektrisch leitfähigen flexiblen Folie als Hilfsträgerschicht bietet den Vorteil, dass auf Grund ihrer hohen Duktilität im Falle von Verunreinigungen (z.B. in Form von Partikeln) zwischen Folie und Schichtenverbundstapel nur ein kleiner Störradius um die Verunreinigung herum entsteht. Eine Einbuße bei der Ausbeute aufgrund von Verunreinigungen kann somit vorteilhafterweise verringert werden.

Weiterhin ermöglicht die Verwendung einer flexiblen Folie als Träger geringere Bauhöhen der Dünnfilm-Halbleiterchips, da die Dicke einer flexiblen Folie geringer sein kann, als die von starren Trägern, bei welchen die Bruchgefahr mit Verringerung der Dicke in der Regel beträchtlich zunimmt.

Die geringe Bauhöhe der Dünnfilm-Halbleiterchips vereinfacht es, später zusätzliche Elemente innerhalb eines Bauelement-Gehäuses auf dem Dünnfilm-Halbleiterchip zu platzieren. Hierbei kann es sich z.B. um Leuchtstoffe handeln, die die Wellenlänge einer von dem Dünnfilm-Halbleiterchip emittierten Strahlung konvertieren. Solche sogenannten Wellenlängenkonversionsmaterialien sind beispielsweise aus der WO 98/12757 A1 beschrieben, deren Offenbarungsgehalt insofern hiermit durch Rückbezug aufgenommen wird. Ebenso denkbar ist das aufbringen von strahlformenden optischen Elementen, wie beispielsweise Linsen, direkt auf den Dünnfilm-Halbleiterchip.

Mit dem Verfahren lassen sich beispielsweise Dünnfilm-Leuchtdioden-Chips (kurz "Dünnfilm-LED-Chips") herstellen.

Ein Dünnfilm-LED-Chip zeichnet sich insbesondere durch folgende charakteristische Merkmale aus:
- an einer zu einem Trägerelement hin gewandten ersten Hauptfläche einer Epitaxieschichtenfolge, die elektromagnetische Strahlung erzeugen kann, ist eine reflektierende Schicht aufgebracht oder ausgebildet, die zumindest einen Teil der in der Epitaxieschichtenfolge erzeugten elektromagnetischen Strahlung in diese zurückreflektiert; und
- die Epitaxieschichtenfolge weist eine Dicke im Bereich von 20µm oder weniger, insbesondere im Bereich von 10 µm auf. Besonders bevorzugt enthält die Epitaxieschichtenfolge enthält mindestens eine Halbleiterschicht mit zumindest einer Fläche, die eine Durchmischungsstruktur aufweist, die im Idealfall zu einer annähernd ergodischen Verteilung des Lichtes in der epitaktischen Epitaxieschichtenfolge führt, d.h. sie weist ein möglichst ergodisch stochastisches Streuverhalten auf.

Ein Grundprinzip einer Dünnfilm-LED ist beispielsweise in I. Schnitzer et al., Appl. Phys. Lett. 63 (16), 18. Oktober 1993, 2174 - 2176 beschrieben, deren Offenbarungsgehalt insofern hiermit durch Rückbezug aufgenommen wird.

Ein Dünnfilm-LED-Chip ist in guter Näherung ein Lambert'scher Oberflächenstrahler.

Vorliegend basiert ein solcher Dünnfilm-Halbleiterchip vorzugsweise auf Nitrid-Verbindungshalbleitermaterial. "Auf Nitrid-Verbindungshalbleitern basierend" bedeutet im vorliegenden Zusammenhang, dass die aktive Epitaxie-Schichtenfolge oder zumindest ein davon ein Nitrid-III/V-Verbindungshalbleitermaterial, vorzugsweise AlₙGaₘIn₁₋ₙ₋ₘN umfasst, wobei 0 ≤ n ≤ 1, 0 ≤ m ≤ 1 und n+m ≤ 1. Dabei muss dieses Material nicht zwingend eine mathematisch exakte Zusammensetzung nach obiger Formel aufweisen. Vielmehr kann es ein oder mehrere Dotierstoffe sowie zusätzliche Bestandteile aufweisen, die die charakteristischen physikalischen Eigenschaften eines des AlₙGaₘIn₁₋ₙ₋ₘN-Materials im Wesentlichen nicht ändern. Der Einfachheit halber beinhaltet obige Formel jedoch nur die wesentlichen Bestandteile des Kristallgitters (Al, Ga, In, N), auch wenn diese teilweise durch geringe Mengen weiterer Stoffe ersetzt sein können.

Bei der flexiblen, elektrisch leitfähigen Folie handelt es sich um eine Karbonfolie, wie sie beispielsweise aus den Druckschriften US 5 695 847 und US 5 849 130 bekannt ist, deren Offenbarungsgehalt insofern hiermit durch Rückbezug aufgenommen wird.

Diese Karbonfolie zeichnet sich neben einem geringen Preis vorteilhafterweise insbesondere durch eine hohe thermische und elektrische Leitfähigkeit, sowie durch eine geringe Dicke aus. Die Karbonfolie besitzt weiterhin den Vorteil, dass sie durch relativ geringe Beaufschlagung mit Druck und Temperatur mit dem Schichtverbund, umfassend die Epitaxie-Schichtenfolge und die Kontaktmaterialschicht verbunden werden kann. Dies verringert die Gefahr einer Schädigung der aktiven Schichtenstapel während des Verbindungsschrittes. Zudem können Dünnfilm-Halbleiterchips, die als unterste Lage eine Karbonfolie beinhalten, einfach auf herkömmliche Weise in ein Gehäuse verbaut und elektrisch kontaktiert werden. Die hohe thermische Leitfähigkeit der Karbonfolie ermöglicht vorteilhafterweise eine effektive Abfuhr der Wärme, die beim Betrieb eines Dünnfilm-Halbleiterchips entsteht.

Bevorzugt hat die elektrisch leitfähige Folie eine Dicke kleiner als 100 µm. Da die Folie im Gegensatz zu einem starren Träger flexibel ist, können solche geringen Trägerdicken realisiert werden.

Zum Schutz des Dünnfilmhalbleiterchips vor Korrosion können zumindest auf Teile der beim Strukturieren freiwerdenden Seitenflächen der Schichtenverbundstapel eine Passivierungsschicht aufgebracht werden, die beispielsweise Siliziumnitrid enthält. Die Passivierungsschicht kann neben ihrer Schutzfunktion auch noch weitere Aufgaben erfüllen, wie beispielsweise elektrische Isolation.

Eine elektrisch leitfähige Verstärkungsschicht, die z.B. ein Metall enthält, kann auf die reflektierende elektrisch leitfähige Kontaktmaterialschicht aufgebracht werden. Diese dient einerseits zur Stabilisierung der aktiven Schichtenfolge und ermöglicht außerdem andererseits eine spätere elektrische Kontaktierung der Dünnfilm-Halbleiterchips über die Rückseite.

Vor dem Entfernen des Wachstumssubstrats kann ein starrer Hilfsträger mit der flexiblen, elektrisch leitfähigen Folie verbunden werden. Dieser zusätzliche starre Hilfsträger versteift den Schichtverbund, so dass dieser in übliche Testsysteme oder Prozessanlagen eingebracht und auf Wafer-Level bearbeitet werden kann.

Die Verwendung einer Karbonfolie als Verbindungsschicht zwischen dem Schichtverbund und dem starren Hilfsträger bietet insbesondere den Vorteil, dass sie kompatibel zu vielen Prozessierungstechnologien ist. So gibt diese anders als beispielsweise Klebstoffschichten unter Vakuum keine eventuell störenden gasförmigen Stoffe an die Umgebung ab.

Nach dem Entfernen des Wachstumssubstrats können auf herkömmliche Weise elektrisch leitfähige weitere Kontaktschichten jeweils auf die Seite der aktiven Schichtstapel aufgebracht werden, die sich vorher auf dem Wachstumssubstrats befunden hat. Diese weiteren elektrisch leitfähigen Kontaktschichten enthalten beispielsweise ein Metall. Diese weiteren Kontaktschichten stellen jeweils die zweite elektrische Kontaktstelle eines jeden Dünnfilm-Halbleiterchips dar, auf der beispielsweise ein Bonddraht aufgebracht werden kann.

Weiterhin kann bevorzugt auf die elektrisch leitfähigen weiteren Kontaktstellen ein Zwischenträger aufgebracht und die flexible, elektrisch leitfähige Folie entfernt werden. Die Dünnfilmhalbleiterchips sind dann voneinander getrennt auf dem Zwischenträger fixiert, von dem sie einfach, z.B. mit herkömmlichen Pick-and-Place Maschinen, abgenommen und verbaut werden können. Bei dem Zwischenträger kann es sich um eine weitere Folie, z.B. eine Sägefolie handeln. Auf einer solchen Sägefolie werden Halbleiterchips im Waferverbund beispielsweise vor dem Vereinzeln mittels eines Wafersäge fixiert.

Vorzugsweise können die Seitenflächen der späteren Dünnfilmhalbleiterchips auch ganzflächig mit der Passivierungsschicht versehen werden. Dies geschieht zweckmäßigerweise nach Verbinden der elektrisch leitfähige Folie mit dem starren Hilfsträger und Ablösen des Wachstumssubstrats. Der starre Hilfsträger stabilisiert den Schichtverbund dann derart, dass dieser in normalen Prozessierungsanlagen mit der Passivierungsschicht versehen werden kann.

Das Vereinzeln der Dünnfilm-Halbleiterchips geschieht dann zweckmäßigerweise ebenfalls dadurch, dass ein weiteren Zwischenträger, beispielsweise eine Folie oder Sägefolie, auf die Seite der aktiven Schichtenstapel aufgebracht wird, die ursprünglich mit dem Wachstumssubstrat verbunden war und die flexible, elektrisch leitfähige Folie entfernt wird.

Ein Dünnfilm-Halbleiterchip beinhaltet:
- eine aktive Schichtenfolge, die geeignet ist, elektromagnetische Strahlung zu erzeugen,
- eine elektrisch leitfähige, reflektierende Kontaktmaterialschicht auf der aktiven Schichtenfolge und
- eine flexible, elektrisch leitfähige Folie als Trägerschicht auf der elektrisch leitfähigen, reflektierenden Kontaktmaterialschicht.

Ein solcher Dünnfilm-Halbleiterchip bietet den Vorteil, dass er eine geringe Bauhöhe, vorzugsweise kleiner als 150 µm und insbesondere kleiner als 100 µm hat. Deshalb kann er ohne erhöhte Bruchgefahr in ein Gehäuse eingebaut werden kann. Auf Grund der geringen Bauhöhe eignet sich ein solcher Dünnfilm-Halbleiterchip besonders dazu, zusammen mit Wellenlängenkonversionsmaterial in ein Gehäuse sehr kleiner Dimensionen eingebaut zu werden.

Weiterhin kann ein solcher Dünnfilm-Halbleiterchip rückseitig einfach über die flexible, elektrisch leitfähige Folie elektrisch kontaktiert werden.

Die Verwendung einer flexiblen Folie verringert zugleich die Bruchgefahr bei der Handhabung und Verbauung des Dünnfilm-Halbleiterchips.

Bei der flexiblen, elektrisch leitfähigen Folie handelt es sich um eine Karbonfolie. Diese zeichnet sich durch besonders hohe elektrische und thermische Leitfähigkeiten sowie einen geringen Preis aus.

Weiter befindet sich auf der elektrisch leitfähigen reflektierenden Kontaktmaterialschicht eine elektrisch leitfähige Verstärkungsschicht. Diese dient der weiteren Verstärkung der aktiven Schichtenfolge und ermöglicht gleichzeitig eine rückseitige Kontaktierung des Dünnfilm-Halbleiterchips über die flexible, elektrisch leitfähige Folie.

Sowohl die reflektierende elektrisch leitfähige Kontaktmaterialschicht, als auch die elektrisch leitfähige Verstärkungsschicht enthalten bevorzugt ein Metall.

Weiterhin sind die Seitenflächen des Dünnfilm-Halbleiterchips bevorzugt ganzlächig mit einer Passivierungsschicht versehen. Ein solcher Dünnfilm-Halbleiterchip eignet sich insbesondere dazu, ohne Bonddraht elektrisch kontaktiert zu werden. So kann ein solcher Dünnfilm-Halbleiterchip rückseitig kontaktiert werden indem er auf einen elektrischen Anschlussleiter aufgebracht wird, der sich beispielsweise auf einem Chip-Träger befindet oder selbst als Chipträger (beispielsweise eines Leadframes) ausgebildet ist. Vorderseitig kann der Dünnfilm-Halbleiterchip dann durch eine ganzflächig oder strukturiert aufgebrachte elektrisch leitfähige Schicht kontaktiert werden, die zweckmäßigerweise eine gute Transmission der von dem Dünnfilm-Halbleiterchip emittierten elektromagnetischen Strahlung ermöglicht.

Weitere Vorteile des Verfahrens bzw. des Halbleiterchips ergeben sich aus den im Folgenden in Verbindung mit den Figuren 1a bis 1f, 2a bis 2c, 3a bis 3b und 4 näher erläuterten Beispielen.

Es zeigen:
Figur 1a bis 1f, eine schematische Darstellung des Verfahrens anhand von schematischen Schnittdarstellungen eines Waferverbundes zu verschiedenen Stadien des Verfahrens,
Figuren 2a bis 2c, eine schematische Darstellung eines weiteren Beispieles des Verfahrens anhand von schematischen Schnittdarstellungen eines Waferverbundes zu verschiedenen Stadien des Verfahrens,
Figuren 3a bis 3b, eine schematische Darstellung noch eines weiteren Beispieles des Verfahrens anhand von schematischen Schnittdarstellungen eines Waferverbundes zu verschiedenen Stadien des Verfahrens, und
Figur 4, eine schematische Schnittdarstellung eines Dünnfilm-Halbleiterchips, der auf einen Chipträger aufgebracht und elektrisch kontaktiert ist.

In den Beispielen und Figuren sind gleiche oder gleichwirkende Bestandteile jeweils mit den gleichen Bezugszeichen versehen. Die dargestellten Elemente der Figuren, insbesondere die Größen von dargestellten Schichtdicken und Schichtdickenverhältnisse, sind grundsätzlich nicht als maßstabsgerecht anzusehen. Vielmehr können sie zum besseren Verständnis teilweise übertrieben groß dargestellt sein.

### Beispiel 1

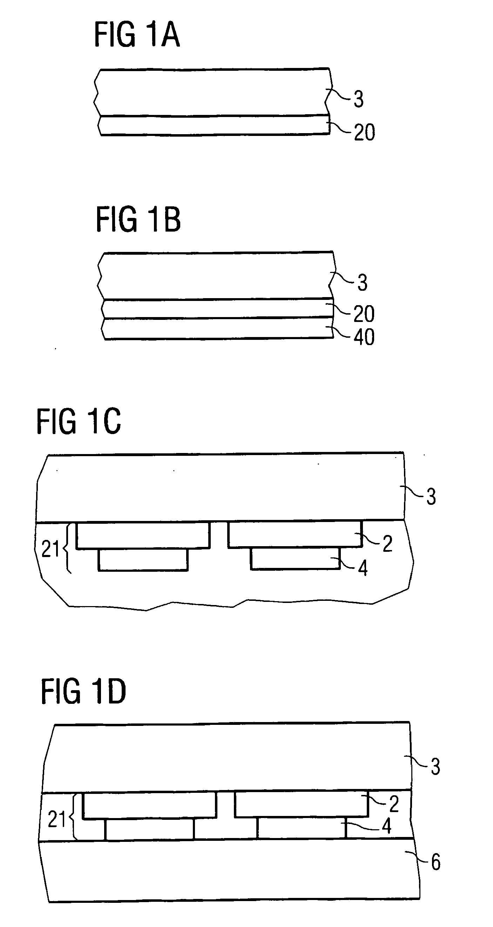

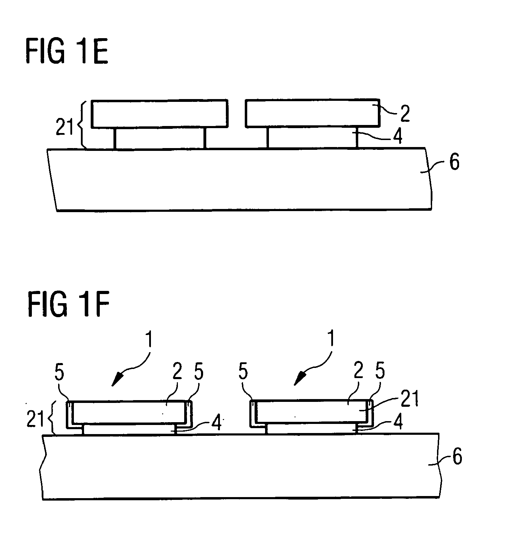

Bei einem Verfahren gemäß Beispiel 1 wird in einem ersten Schritt eine aktive Schichtenfolge 20 auf einem Wachstumssubstrat 3 aufgebracht (Figur 1a). Dies erfolgt beispielsweise durch epitaktisches Wachstum mehrerer unterschiedlicher Schichten aus Nit-rid-III/V-Verbindungshalbleitermaterial, vorzugsweise aus dem System AlₙGaₘInₗ₋ₙ₋ₘN, wobei 0 ≤ n ≤ 1, 0 ≤ m ≤ 1 und n+m ≤ 1, auf einem Saphir- oder SiC-Substrat. Dies schließt natürlich nicht aus, dass neben In, Al und/oder Ga und N in der Zusammensetzung auch weitere Elemente enthalten sein können.

Eine solche zur Erzeugung von elektromagnetischer Strahlung geeignete aktive Schichtenfolge kann beispielsweise einen herkömmlichen pn-Übergang, eine Doppelheterostruktur, eine Einfach-Quantentopfstruktur (SQW-Struktur) oder eine Mehrfach-Quantentopfstruktur (MQW-Strukur) aufweisen. Solche Strukturen sind dem Fachmann bekannt und werden von daher an dieser Stelle nicht näher erläutert. Eine geeignete Quantentopfstruktur ist beispielsweise aus der WO01/39282 bekannt, deren Offenbarungsgehalt insofern hiermit durch Rückbezug aufgenommen wird.

Anschließend wird auf der aktiven Schichtenfolge 20 eine elektrische leitfähige reflektierende Kontaktmaterialschicht 40 ausgebildet (Figur 1b). Diese Kontaktmaterialschicht 40 hat in einem späteren Dünnfilm-Halbleiterchip 1 unter anderem die Aufgabe, Strahlung, die von der aktiven Schichtenfolge 20 in Richtung dieser Kontaktmaterialschicht 40 emittiert wird, zu der dieser gegenüberliegenden Abstrahlseite des Dünnfilm-Halbleiterchips 1 hin zu reflektieren, um die Strahlungsausbeute zu erhöhen.

Die Kontaktmaterialschicht 40, kann ganzflächig ein metallisches Material enthalten, wie Ag, Al oder Au, das aufgedampft werden kann. Weiterhin können dielektrische Reflektoren eingesetzt werden, die aus mehreren dielektrischen Schichten mit integrierten elektrischen Kontakten bestehen.

Geeignete Reflektoren sind beispielsweise aus der WO 01/82384 bekannt, deren Offenbarungsgehalt insofern hiermit durch Rückbezug aufgenommen wird.

Gleichzeitig fungiert die Kontaktmaterialschicht 40 als rückseitige Kontaktmaterialschicht für die aktive Schichtenfolge 20. Die aktive Schichtenfolge 20 und die reflektierende elektrisch leitfähige Kontaktmaterialschicht 40 haben zusammen beispielsweise eine Dicke von 8 *µ*m.

In einem nachfolgenden Schritt werden aus dem Schichtenverbund mit aktiver Schichtenfolge 20 und Kontaktmaterialschicht 40 auf dem Wachstumssubstrat 1 voneinander getrennte aktive Schichtstapel 2 mit jeweils einer elektrisch leitfähigen reflektierenden Kontaktmaterialschicht 4 gebildet (Figur 1c). Dies erfolgt beispielsweise durch nasschemisches Ätzen oder durch Trockenätzen.

Alternativ kann die Kontaktmaterialschicht 40 auch lateral strukturiert, z.B. durch eine Maske, auf die aktive Schichtenfolge 20 aufgebracht werden und die aktive Schichtenfolge 20 anschließend so zu aktiven Schichtstapeln 2 strukturiert werden, dass sich auf einem aktiven Schichtstapel 2 je eine elektrisch leitfähige reflektierende Kontaktmetallschicht 4 befindet.

Anschließend wird auf die elektrisch leitfähigen reflektierenden Kontaktmaterialschichten 4 eine flexible elektrisch leitfähige Folie 6 aufgebracht. Hierbei kann es sich beispielsweise um eine Karbonfolie mit einer Dicke zwischen 30 und 80 *µ*m handeln.

Die Karbonfolie bietet den Vorteil, dass sie bei Temperaturen ≤ 150 °C und unter relativ geringen Druck (ca. 1 bar) mit den Schichtverbundstapeln 21 verbunden werden kann.

Zur Durchführung dieses Verbindungsprozesses kann die Karbonfolie auf einen Halter aufgebracht werden. Damit sich die Karbonfolie während des Prozesses nicht auch mit diesem Halter verbindet, kann beispielsweise eine Antihaftfolie, z. B. aus Teflon, zwischen Halter und Karbonfolie eingebracht werden. Selbstverständlich kann eine solche Antihaftfolie während des Verbindungsprozesses auch an anderen Stellen eingesetzt werden, an denen die Gefahr besteht, dass die Karbonfolie unbeabsichtigt mit anderen Flächen verbunden wird.

In einem nächsten Schritt wird das Wachstumssubstrat 1 entfernt, auf dem die aktive Schichtenfolge 20 aufgewachsen wurde, z. B. durch einen Laser-Lift-Off-Prozess, wie er beispielsweise in der WO 98/14986 beschrieben ist. Wie in Figur le dargestellt, befinden sich die aktiven Schichtenstapel 2 mit einer rückseitigen reflektierenden elektrisch leitfähigen Kontaktierungsschicht 4 nun nebeneinander auf der flexiblen, elektrisch leitfähigen Folie 6.

Als ein zusätzlicher Schritt kann nach dem Strukturieren der Schichtverbundstapel 21 eine Passivierungsschicht 5 auf den Seitenflächen der Schichtverbundstapel 21 zumindest teilweise ausgebildet werden, wie in Figur 1f. dargestellt. Diese kann beispielsweise aus Siliziumnitrid, Aluminiumoxid, Aluminiumnitrid oder Siliziumoxinitrid bestehen.

Die Dünnfilmhalbleiterchips 1 können durch Trennen der Folie (6) mit Hilfe herkömmlicher Methoden, wie Laserschneiden, Wasserstrahlschneiden oder Sägen vereinzelt werden. Dünnfilm-Halbleiterchips 1, die rückseitig mit einer Karbonfolie 6 versehen sind, können einfach durch Beaufschlagung mit Druck und Temperatur vermittels der Karbonfolie 6 in einem Gehäuse befestigt werden. Alternativ lässt sich ein solcher Dünnfilm-Halbleiterchip 1 mittels Kleben mit einem Gehäuse verbinden.

### Beispiel 2

Analog zu Beispiel 1 werden die ersten drei Verfahrensschritte, Herstellen der aktiven Schichtenfolge 20, Aufbringen einer elektrisch leitfähigen Kontaktmaterialschicht 40 und Strukturieren dieser beiden Schichten zu Schichtverbundstapeln 21 durchgeführt. Im Unterschied zu Beispiel 1 wird nun eine weitere elektrisch leitfähige Verstärkungsschicht 7 auf die Kontaktmaterialschicht 4 des Schichtverbundstapels 21 aufgebracht, so dass dieser nun mindestens drei Schichten beinhaltet. Die elektrisch leitfähige Verstärkungsschicht 7 kann beispielsweise aus einem metallischen Material bestehen, dass galvanisch aufgebracht wird.

Die Dicke der aktiven Schichtenfolge 2 einschließlich der reflektierenden elektrisch leitfähigen Kontaktmaterialschicht 4 und der metallischen Verstärkungsmaterialschicht 7 liegt z. B. zwischen 20 *µ*m und 25 *µ*m.

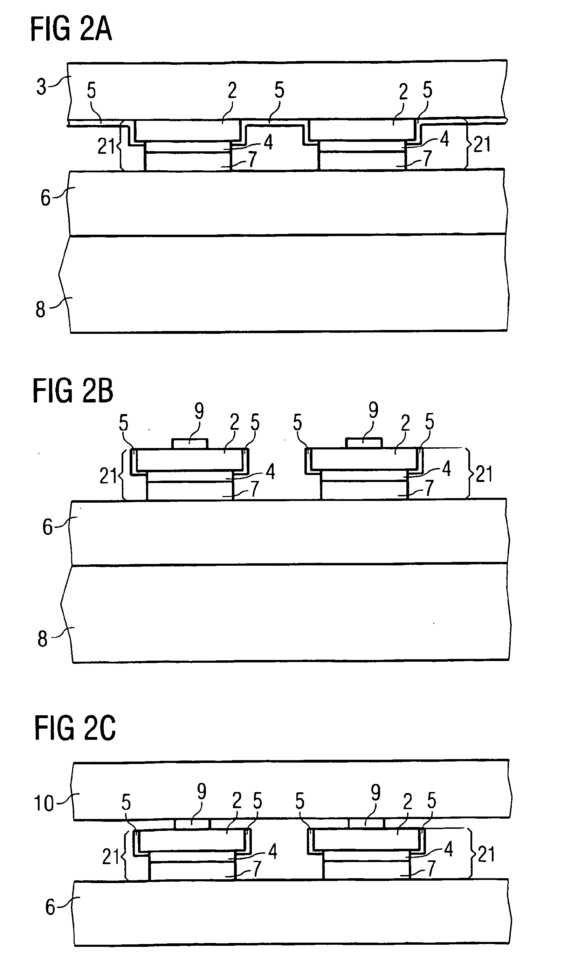

Nach dem Strukturieren der Schichtenfolge 20 einschließlich der reflektierenden elektrisch leitfähigen Kontaktmaterialschicht 40 zu voneinander getrennten aktiven Schichtenverbundstapeln 2 und dem Aufbringen der metallischen Verstärkungsmaterialschicht 7 wird eine Passivierungsschicht 5 auf freiliegenden Seitenflächen der aktiven Schichtenstapel 2 aufgebracht und eine Karbonfolie 6 auf die den Schichtenverbundstapeln 2 zugeordneten metallischen Verstärkungsschichten 7 aufgebracht (Figur 2a).

Um den so entstandenen Schichtverbund weiter zu verstärken, kann auf die Rückseite der Karbonfolie 6 wiederum durch die Beaufschlagung mit Druck und Temperatur ein weiterer starrer stabiler Hilfsträger 8 aufgebracht werden, dessen Dicke z.B. zwischen 100 und 150 *µ*m beträgt. Es können auch dickere Träger verwendet werden.

Dieser starre Hilfsträger 8 ermöglicht eine vereinfachte Handhabung des Schichtverbundes und ein weiteres Prozessieren des Schichtverbundes in herkömmlichen LED-Fertigungsanlagen. Besteht der starre Hilfsträger zudem aus einem elektrisch leitfähigen Material, wie z.B. Molybdän Tantal oder Wolfram, können die späteren Dünnfilm-Halbleiterchips 1 noch auf Wafer-Level rückseitig elektrisch kontaktiert werden. Dies ermöglicht ein Testen aller Dünnfilm-Halbleiterchips 1, die auf einem Wafer hergestellt wurden, in herkömmlichen Messgeräten.

In einem weiteren Schritt wird wieder das Wachstumssubstrat 3 entfernt (Figur 2b) und auf den Vorderseiten der aktiven Schichtstapel 2, die vorher mit dem Wachstumssubstrat 1 verbunden waren, elektrisch leitfähige metallische Kontaktstellen 9 ausgebildet. Diese können beispielsweise Ag, Au oder Al enthalten, dass aufgedampft wird.

Danach können alle Dünnfilm-Halbleiterchips 1, jeweils bestehend aus aktivem Schichtstapel 2, elektrischer Kontaktmaterialschicht 4, Verstärkungsschicht 7, Karbonfolie 6 und Kontaktstelle 9, in herkömmlichen Testsystemen im Waferverbund getestet werden.

Wie in Figur 2c dargestellt, kann nun auf die Vorderseiten der elektrisch leitfähigen Kontaktstellen 9 ein Zwischenträger 10 aufgebracht werden. Hierbei kann es sich um eine Folie handeln, wie sie auch beim Sägen von Wafern eingesetzt wird. Durch selektives Entfernen der Karbonfolie 6, beispielsweise nasschemisch, können die Dünnfilm-Halbleiterchips 1 wieder von dem starre Hilfsträger 8 entfernt und gleichzeitig vereinzelt werden. Die einzelnen Dünnfilm-Halbleiterchips 1 auf dem Zwischenträger 10 stehen nun für eine herkömmliche Weiterprozessierung, wie beispielsweise Montage auf Leadframes und/oder Gehäusekörper, bereit.

### Beispiel 3

Wie in den Beispielen 1 und 2 beschrieben, werden Schichtverbundstapel 21 im Waferverbund hergestellt, von denen jeder einen aktiven Schichtstapel 2 mit einer reflektierende elektrisch leitfähige Kontaktmaterialschicht 4 beinhaltet, auf dem sich optional eine weitere elektrisch leitfähige Verstärkungsschicht 7 befindet. Diese Schichtverbundstapel 21 befinden sich auf nach dem Entfernen des Wachstumssubstrates 3 auf der elektrisch leitfähigen Folie 6, die mit einem starren Hilfsträger 8 verbunden sein kann.

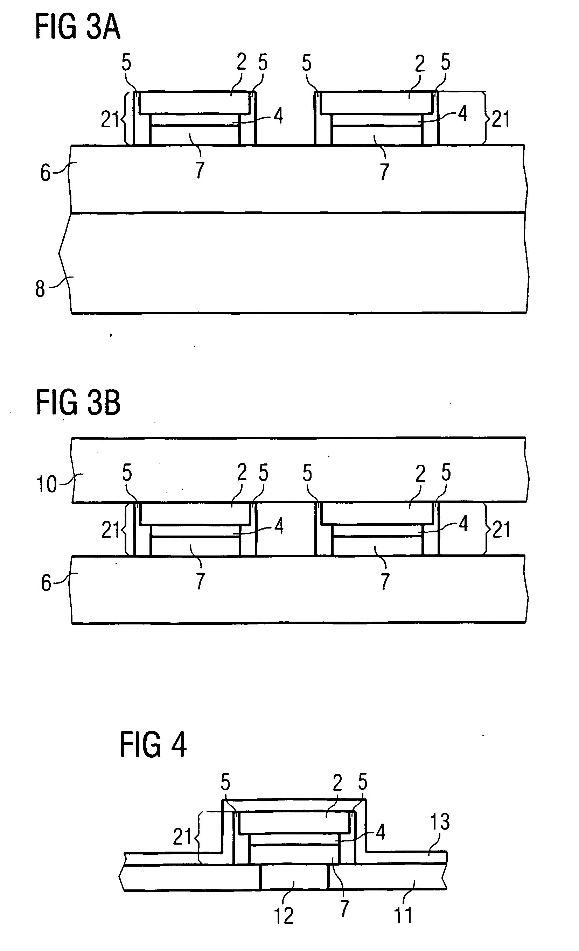

Wie in Figur 3a gezeigt, kann die Passivierungsschicht 5 auf den Seiten der späteren Dünnfilm-Halbleiterchips 1 bestehend aus den aktiven Schichtstapeln 2, der reflektierenden elektrisch leitfähigen Kontaktmaterialschicht 4 und der metallischen Verstärkungsschicht 7 auch ganzflächig aufgebracht werden.

Zweckmäßigerweise wird hierzu die Passivierungsschicht 5 aufgebracht nachdem der Schichtverbund bestehend aus aktivem Schichtstapel 2, reflektierender elektrisch leitfähiger Kontaktmaterialschicht 4 und optionaler metallischer Verstärkungsschicht 7 über die Karbonfolie 6 mit einem starre Hilfsträger 8 verbunden wurde. Die Dünnfilm-Halbleiterchips 1 können anschließend durch selektives Entfernen der Karbonfolie 6 vereinzelt werden.. Der Dünnfilm-Halbleiterchip 1 liegt danach mit vollständiger seitlicher Isolierung vor. Ein zusätzlicher Passivierungsschritt in der späteren Bauform kann somit entfallen. Ein solcher muss üblicherweise bei Dünnfilm-Halbleiterchips 1 durchgeführt werden, die nach Standardverfahren hergestellt werden.

Figur 3b zeigt Dünnfilm-Halbleiterchips 1 mit seitlich ganzflächiger Passivierungsschicht 5 auf einer flexiblen elektrisch leitfähigen Folie 6, die mit einem starren stabilen Hilfsträger 8 verbunden sind. Besteht der starre Hilfsträger 8 aus einem elektrisch leitfähigen Material, wie z.B. Molybdän, zeigt Figur 3b wiederum den Zustand, in dem die späteren Dünnfilm-Halbleiterchips 1 gleichzeitig getestet werden können.

### Beispiel 4

In Figur 4 ist ein Dünnfilm-Halbleiterchip 1 dargestellt, der aus einem aktiven Schichtstapel 2 besteht, auf dem sich rückseitig eine reflektierende elektrisch leitfähige Kontaktmaterialschicht 4 befindet, die wiederum durch eine metallische Verstärkungsschicht 7 verstärkt ist. Die Seiten der Dünnfilm-Halbleiterchips 1 sind hierbei ganzflächig mit einer Passivierungsschicht 5 bedeckt.

Ein solcher Dünnfilm-Halbleiterchip 1 eignet sich insbesondere dazu, nach dem Aufbringen auf einen geeigneten Chipträger 11, ohne Bonddraht elektrisch kontaktiert zu werden.

Hierzu wird der Dünnfilm-Halbleiterchip 1 auf einen geeigneten Chipträger 11, wie beispielsweise eine Leiterplatte, aufgebracht. Dieser beinhaltet zweckmäßigerweise elektrisch leitfähige Strukturen 12 zur rückseitigen Kontaktierung des späteren Dünnfilm-Halbleiterchips, während der Rest des Chipträgers 11 aus einem elektrisch isolierenden Material wie beispielsweise einem Kunststoff besteht. Die Dünnfilm-Halbleiterchips werden auf den elektrisch leitfähigen Strukturen 12 des Chipträgers 11 positioniert und anschließend durch ganzflächiges Aufbringen einer elektrisch leitfähigen Schicht 13 über den Dünnfilm-Halbleiterchip 1 und auf die Oberfläche des Chipträgers 11 elektrisch kontaktiert. Zweckmäßigerweise besteht diese elektrisch leitfähige Schicht 13 aus einem Material, das einen hohen Transmissionskoeffizienten für die von dem Dünnfilm-Halbleiterchip emittierte elektromagnetische Strahlung hat, wie z. B. Indium-Zinn-Oxid (ITO) oder Zinkoxid.

Der Vollständigkeit halber sei darauf hingewiesen, dass die Erfindung selbstverständlich nicht auf die Ausführungsbeispiele eingeschränkt ist, sondern dass alle Ausführungsformen in den Bereich der Erfindung fallen, denen deren im allgemeinen Teil erläutertes grundsätzliches Prinzip zugrunde liegt. Gleichzeitig sei darauf hingewiesen, dass die verschiedenen Elemente der unterschiedlichen Ausführungsbeispiele untereinander kombiniert werden können ohne dass dabei der Grundgedanke der Erfindung verlassen wird.

## Patentansprüche

1. Verfahren zur Herstellung von Dünnfilm-Halbleiterchips (1) mit den Schritten:
- Aufbringen einer aktiven Schichtenfolge (20), die geeignet ist elektromagnetische Strahlung zu erzeugen, auf ein Wachstumssubstrat (3),
- Ausbilden einer reflektierenden elektrisch leitfähigen Kontaktmaterialschicht (40) auf der aktiven Schichtenfolge,
- Strukturieren der aktiven Schichtenfolge einschließlich Kontaktmaterialschicht (40) zu voneinander getrennten aktiven Schichtenverbundstapeln (21), auf dem Wachstumssubstrat (3),
- Aufbringen einer Karbonfolie als flexible elektrisch leitfähige Folie (6) auf die reflektierende elektrisch leitfähige Kontaktmaterialschicht (4), und
- Zumindest teilweises Entfernen des Wachstumssubstrats (3).

2. Verfahren nach Anspruch 1, bei dem die Dicke der elektrisch leitfähige Folie (6) kleiner als 100 µm ist.

3. Verfahren nach einem der obigen Ansprüche, bei dem die elektrisch leitfähige Kontaktmaterialschicht (40) ein Metall enthält.

4. Verfahren nach einem der obigen Ansprüche, bei dem zumindest auf Teilen der beim Strukturieren freigelegten Seitenflächen der Schichtenverbundstapel (21) eine Passivierungsschicht ausgebildet wird.

5. Verfahren nach einem der obigen Ansprüche, bei dem eine elektrisch leitfähige Verstärkungsschicht (7) auf die reflektierende elektrisch leitfähige Kontaktmaterialschicht (4) aufgebracht wird.

6. Verfahren nach Anspruch 5, bei dem die elektrisch leitfähige Verstärkungsschicht (7) ein Metall enthält.

7. Verfahren nach einem der obigen Ansprüche, bei dem vor dem Entfernen des Wachstumssubstrats (3) ein starrer Hilfsträger (8) mit der flexiblen elektrisch leitfähigen Folie (6) verbunden wird.

8. Verfahren nach einem der obigen Ansprüche, bei dem nach dem Entfernen des Wachstumssubstrates (3) elektrisch leitfähige Kontaktstellen (9) auf die Seite der aktiven Schichtenfolge der Schichtenstapeln (2) aufgebracht werden, auf der sich vorher das Wachstumssubstrat (3) befand.

9. Verfahren nach Anspruch 8, bei dem die elektrisch leitfähigen Kontaktstellen ein Metall enthalten.

10. Verfahren nach Anspruch 8 oder 9, bei dem auf die elektrisch leitfähigen Kontaktstellen (9) ein Zwischenträger (10) aufgebracht wird und die flexible elektrisch leitfähige Folie (6) entfernt wird, so dass die Dünnfilmhalbleiterchips vereinzelt auf dem Zwischenträger vorliegen.

11. Verfahren nach Anspruch 10, bei dem als Zwischenträger eine weitere Folie verwendet wird.

12. Verfahren nach Anspruch 10 oder 11, bei dem die Passivierungsschicht (5) ganzflächig auf den Seitenflächen der Schichtenverbundstapel (2) aufgebracht wird.

13. Verfahren nach einem der Ansprüche 8 bis 12, bei dem nach Entfernen des Wachstumssubstrates (3) ein Zwischenträger (10) auf die aktiven Schichtenverbundstapel (21) aufgebracht wird, auf der sich vorher das Wachstumssubstrates (3) befand, und
nachfolgend die flexible elektrisch leitfähige Folie (6) entfernt wird, so dass die Dünnfilmhalbleiterchips (1) vereinzelt auf dem Zwischenträger (10) vorliegen.

14. Verfahren nach Anspruch 13, bei dem als Zwischenträger (10) eine weitere Folie verwendet wird.

15. Dünnfilm-Halbleiterchip (1), der umfasst:
- einen aktiven Schichtenstapel (2), der geeignet ist, elektromagnetische Strahlung zu erzeugen,
- eine elektrisch leitfähige reflektierende Kontaktmaterialschicht (4) auf dem aktiven Schichtenstapel (2), und
- eine Trägerschicht aus einer Karbonfolie als flexible elektrisch leitfähige Folie (6) auf der elektrisch leitfähigen reflektierenden Kontaktmaterialschicht (4).

16. Dünnfilm-Halbleiterchip nach Anspruch 15, bei dem die elektrisch leitfähigen reflektierenden Kontaktmaterialschicht (4) ein metallisches Material enthält.

17. Dünnfilm-Halbleiterchip nach Anspruch 15 oder 16, bei dem sich zwischen der Trägerschicht und der reflektierenden elektrisch leitfähigen Kontaktmaterialschicht (4) eine elektrisch leitende Verstärkungsschicht (7) befindet.

18. Dünnfilm-Halbleiterchip nach Anspruch 17, bei dem die elektrisch leitende Verstärkungsschicht (7) ein metallisches Material enthält.

19. Dünnfilm-Halbleiterchip (1) nach einem der Ansprüche 15 bis 18, bei dem Seitenflächen der Dünnfilm-Halbleiterchips (1) zumindest teilweise mit einer Passivierungsschicht (5) versehen sind.

20. Dünnfilm-Halbleiterchip (1) nach einem der Ansprüche 15 bis 18, bei dem Seitenflächen der Dünnfilm-Halbleiterchips (1) ganzflächig mit einer Passivierungsschicht (5) versehen sind.

21. Dünnfilm-Halbleiterchip (1) nach einem der Ansprüche 15 bis 19, dessen gesamte Dicke kleiner als 150 µm und insbesondere kleiner als 100 µm ist.

## Claims

1. Process for producing thin film semiconductor chips (1) comprising the steps of:
- applying an active layer sequence (20), which is suitable for generating electromagnetic radiation, to a growth substrate (3),
- forming a reflective electrically conductive contact material layer (40) on the active layer sequence,
- patterning the active layer sequence including contact material layer (40) to form active layer composite stacks (21), which are separate from one another, on the growth substrate (3),
- applying a carbon film as flexible electrically conductive film (6) to the reflective electrically conductive contact material (4), and
- at least partially removing the growth substrate (3).

2. Process according to Claim 1, in which the thickness of the electrically conductive film (6) is less than 100 µm.

3. Process according to one of the preceding claims, in which the electrically conductive contact material layer (40) contains a metal.

4. Process according to one of the preceding claims, in which a passivation layer is formed at least on parts of the side faces of the layer composite stacks (21) which are uncovered during the patterning step.

5. Process according to one of the preceding claims, in which an electrically conductive reinforcing layer (7) is applied to the reflective electrically conductive contact material layer (4).

6. Process according to Claim 5, in which the electrically conductive reinforcing layer (7) contains a metal.

7. Process according to one of the preceding claims, in which, prior to the removal of the growth substrate (3), a rigid auxiliary carrier (8) is joined to the flexible electrically conductive film (6).

8. Process according to one of the preceding claims, in which, after the growth substrate (3) has been removed, electrically conductive contact locations (9) are applied to that side of the active layer sequence of the layer stacks (2) on which the growth substrate (3) was previously located.

9. Process according to Claim 8, in which the electrically conductive contact locations contain a metal.

10. Process according to Claim 8 or 9, in which an intermediate carrier (10) is applied to the electrically conductive contact locations (9) and the flexible electrically conductive film (6) is removed so that individual thin film semiconductor chips are present on the intermediate carrier.

11. Process according to Claim 10, in which the intermediate carrier used is a further film.

12. Process according to Claim 10 or 11, in which the passivation layer (5) is applied to the entire area of the side faces of the layer composite stacks (2).

13. Process according to one of Claims 8 to 12, in which following removal of the growth substrate (3) an intermediate carrier (10) is applied to the active layer composite stacks (21) on which the growth substrate (3) was previously located, and then the flexible, electrically conductive film (6) is removed, so that the thin film semiconductor chips (1) are located individually on the intermediate carrier (10).

14. Process according to Claim 13, in which the intermediate carrier (10) used, is a further film.

15. Thin film semiconductor chip (1) which comprises:
- an active layer stack (2) which is suitable for generating electromagnetic radiation,
- an electrically conductive reflective contact material layer (4) on the active layer stack (2), and
- a carrier layer comprising a carbon film as flexible electrically conductive film (6) on the electrically conductive reflective contact material layer (4).

16. Thin film semiconductor chip according to Claim 15, in which the electrically conductive reflective contact material layer (4) contains a metallic material.

17. Thin film semiconductor chip according to Claim 15 or 16, in which an electrically conductive reinforcing layer (7) is located between the carrier layer and the reflective electrically conductive contact material layer (4).

18. Thin film semiconductor chip according to Claim 17, in which the electrically conductive reinforcing layer (7) contains a metallic material.

19. Thin film semiconductor chip (1) according to one of Claims 15 to 18, in which side faces of the thin film semiconductor chips (1) are at least partially provided with a passivation layer (5).

20. Thin film semiconductor chip (1) according to one of Claims 15 to 18, in which side faces of the thin film semiconductor chips (1) are provided with a passivation layer (5) over their entire area.

21. Thin film semiconductor chip (1) according to one of Claims 15 to 19, the total thickness of which is less than 150 µm and in particular less than 100 µm.

## Revendications

1. Procédé de fabrication de puces semi-conductrices à couches minces (1), comprenant les étapes suivantes :
- l'application d'une série de couches active (20), qui est appropriée pour la génération d'un rayonnement électromagnétique, sur un substrat de croissance (3),
- la formation d'une couche de matériau de contact électriquement conductrice réfléchissante (40) sur la série de couches active,
- la structuration de la série de couches active, y compris la couche de matériau de contact (40), en piles composites de couches actives séparées les unes des autres (21) sur le substrat de croissance (3),
- l'application d'une feuille de carbone en tant que feuille électriquement conductrice flexible (6) sur la couche de matériau de contact électriquement conductrice réfléchissante (4), et
- l'élimination au moins partielle du substrat de croissance (3).

2. Procédé selon la revendication 1, dans lequel l'épaisseur de la feuille électriquement conductrice (6) est inférieure à 100 µm.

3. Procédé selon l'une quelconque des revendications précédentes, dans lequel la couche de matériau de contact électriquement conductrice (40) contient un métal.

4. Procédé selon l'une quelconque des revendications précédentes, dans lequel une couche de passivation est formée au moins sur des parties des surfaces latérales des piles composites de couches (21) exposées lors de la structuration.

5. Procédé selon l'une quelconque des revendications précédentes, dans lequel une couche de renforcement électriquement conductrice (7) est appliquée sur la couche de matériau de contact électriquement conductrice réfléchissante (4).

6. Procédé selon la revendication 5, dans lequel la couche de renforcement électriquement conductrice (7) contient un métal.

7. Procédé selon l'une quelconque des revendications précédentes, dans lequel, avant l'élimination du substrat de croissance (3), un support auxiliaire rigide (8) est relié avec la feuille électriquement conductrice flexible (6).

8. Procédé selon l'une quelconque des revendications précédentes, dans lequel, après l'élimination du substrat de croissance (3), des emplacements de contact électriquement conducteur (9) sont appliqués sur le côté de la série de couches active des piles de couches (2) sur lequel le substrat de croissance (3) se trouvait auparavant.

9. Procédé selon la revendication 8, dans lequel les emplacements de contact électriquement conducteurs contiennent un métal.

10. Procédé selon la revendication 8 ou 9, dans lequel un support intermédiaire (10) est appliqué sur les emplacements de contact électriquement conducteurs (9) et la feuille électriquement conductrice flexible (6) est éliminée de manière à ce que les puces semi-conductrices à couches minces se présentent sous forme isolée sur le support intermédiaire.

11. Procédé selon la revendication 10, dans lequel une feuille supplémentaire est utilisée en tant que support intermédiaire.

12. Procédé selon la revendication 10 ou 11, dans lequel la couche de passivation (5) est appliquée sur l'ensemble de la surface des surfaces latérales des piles composites de couches (2).

13. Procédé selon l'une quelconque des revendications 8 à 12, dans lequel, après l'élimination du substrat de croissance (3), un support intermédiaire (10) est appliqué sur les piles composites de couches actives (21) sur lesquelles le substrat de croissance (3) se trouvait auparavant, puis la feuille électriquement conductrice flexible (6) est éliminée de manière à ce que les puces semi-conductrices à couches minces (1) se présentent sous forme isolée sur le support intermédiaire (10).

14. Procédé selon la revendication 13, dans lequel une feuille supplémentaire est utilisée en tant que support intermédiaire (10).

15. Puce semi-conductrice à couches minces (1), qui comprend :
- une pile de couches active (2), qui est appropriée pour la génération d'un rayonnement électromagnétique,
- une couche de matériau de contact réfléchissante électriquement conductrice (4) sur la pile de couches active (2), et
- une couche support constituée d'une feuille de carbone en tant que feuille électriquement conductrice flexible (6) sur la couche de matériau de contact réfléchissante électriquement conductrice (4).

16. Puce semi-conductrice à couches minces selon la revendication 15, dans laquelle la couche de matériau de contact réfléchissante électriquement conductrice (4) contient un matériau métallique.

17. Puce semi-conductrice à couches minces selon la revendication 15 ou 16, dans laquelle une couche de renforcement électriquement conductrice (7) se trouve entre la couche support et la couche de matériau de contact électriquement conductrice réfléchissante (4).

18. Puce semi-conductrice à couches minces selon la revendication 17, dans laquelle la couche de renforcement électriquement conductrice (7) contient un matériau métallique.

19. Puce semi-conductrice à couches minces (1) selon l'une quelconque des revendications 15 à 18, dans laquelle des surfaces latérales de la puce semi-conductrice à couches minces (1) sont munies au moins en partie d'une couche de passivation (5).

20. Puce semi-conductrice à couches minces (1) selon l'une quelconque des revendications 15 à 18, dans laquelle des surfaces latérales de la puce semi-conductrice à couches minces (1) sont munies sur l'ensemble de la surface d'une couche de passivation (5).

21. Puce semi-conductrice à couches minces (1) selon l'une quelconque des revendications 15 à 19, dont l'épaisseur totale est inférieure à 150 µm et notamment inférieure à 100 µm.
